# EUROPÄISCHE PATENTSCHRIFT

(11) **EP 2 865 023 B1**
(45) Veröffentlichungstag und Bekanntmachung des Hinweises auf die Patenterteilung: **27.03.2019**
(21) Anmeldenummer: 13730541.3
(22) Anmeldetag: 19.06.2013
(51) Int. Cl.: H01L 35/32, H01L 35/04

(54) **THERMOELEKTRISCHES MODUL, WÄRMETAUSCHER, ABGASANLAGE UND BRENNKRAFTMASCHINE**
THERMOELECTRIC MODULE, HEAT EXCHANGER, EXHAUST GAS SYSTEM AND INTERNAL COMBUSTION ENGINE
MODULE THERMOÉLECTRIQUE, ÉCHANGEUR THERMIQUE, SYSTÈME DE GAZ D'ÉCHAPPEMENT ET MOTEUR À COMBUSTION INTERNE

(30) Priorität: 22.06.2012 DE 102012210627
(43) Veröffentlichungstag der Anmeldung: 29.04.2015
(73) Patentinhaber: Eberspächer Exhaust Technology GmbH & Co. KG, 66539 Neunkirchen (DE)
(72) Erfinder: OESTERLE, Jörg Johannes, 89150 Laichingen (DE); RESCH, Andreas, 71032 Böblingen (DE); LEICHT, Sebastian, 72406 Bisingen (DE); SPIETH, Arnulf, 73269 Hochdorf (DE); TCHAMGOUE, Herve, 73730 Esslingen (DE)
(74) Vertreter: BRP Renaud & Partner mbB Rechtsanwälte Patentanwälte Steuerberater
(86) Internationale Anmeldenummer: PCT/EP2013/062710
(87) Internationale Veröffentlichungsnummer: WO 2013/189970

(56) Entgegenhaltungen:
- DE-B3-102010 063 460
- GB-A- 2 119 170
- US-A- 5 837 929
- US-A1- 2011 275 165

## Beschreibung

Die vorliegende Erfindung betrifft ein thermoelektrisches Modul zur Wandlung von thermischer Energie in elektrische Energie, mit den Merkmalen des Oberbegriffs des Anspruchs 1. Die Erfindung betrifft außerdem einen mit wenigstens einem derartigen thermoelektrischen Modul ausgestatteten Wärmetauscher. Ferner betrifft die Erfindung eine Abgasanlage sowie eine Brennkraftmaschine, die mit einem derartigen Wärmetauscher ausgestattet sind.

Ein thermoelektrisches Modul kann unter Ausnutzung des sogenannten Seebeck-Effekts einen Wärmestrom in einen elektrischen Strom wandeln. Der Seebeck-Effekt beruht dabei auf einer Invertierung des Peltier-Effekts. Derartige thermoelektrische Module lassen sich daher zur Wärmerückgewinnung bzw. zur Gewinnung elektrischer Energie aus Wärme nutzen und können dementsprechend in Abgasanlagen von Brennkraftmaschinen, vorzugsweise in Kraftfahrzeugen, zur Anwendung kommen, um den energetischen Wirkungsgrad der Brennkraftmaschine bzw. des Fahrzeugs zu verbessern.

Im Einzelnen umfasst ein thermoelektrisches Modul üblicherweise eine Vielzahl von Bein-Paaren, die jeweils ein p-dotiertes Halbleiterbein und ein n-dotiertes Halbleiterbein aufweisen, wobei die Halbleiterbeine über Metallbrücken elektrisch miteinander kontaktiert sind. Die Bein-Paare können im Folgenden auch als LEG-Paare bezeichnet werden. In jedem einzelnen LEG-Paar findet eine Umwandlung von thermischer Energie in elektrische Energie statt. Die Vielzahl der LEG-Paare ist ferner innerhalb des jeweiligen thermoelektrischen Moduls so verschaltet, vorzugsweise in Reihe, dass das jeweilige thermoelektrische Modul zweckmäßig nur einen Plus-Pol und nur einen Minus-Pol besitzt, an denen die elektrische Energie abgreifbar ist. Die Verschaltung der LEG-Paare kann dabei insbesondere über die Metallbrücken erfolgen.

Ein thermoelektrisches Modul weist ferner eine Warmseite und eine Kaltseite auf, an denen die Temperaturdifferenz anzulegen ist, um einen Wärmestrom durch das thermoelektrische Modul zu erzeugen, der darin in elektrischen Strom gewandelt werden kann. Üblicherweise sind an einem derartigen thermoelektrischen Modul die Kaltseite und die Warmseite jeweils durch eine elektrisch isolierende Keramikplatte gebildet, an der die Metallbrücken flächig anliegen und daran befestigt sind.

Um nun innerhalb eines Wärmetauschers ein Heizrohr, das ein Heizfluid, zum Beispiel Abgas einer Abgasanlage, führt, sowie ein Kühlrohr, das ein Kühlfluid, zum Beispiel ein Kühlmittel eines Kühlkreises, führt, mit der Warmseite bzw. mit der Kaltseite eines derartigen thermoelektrischen Generators oder Moduls wärmeübertragend zu koppeln, ist es zur Verbesserung der Wärmeübertragung üblich, eine Vorspannung zu erzeugen, die das jeweilige Rohr gegen das thermoelektrische Modul andrückt.

Da die Keramikplatten des thermoelektrischen Moduls eine hohe Biegesteifigkeit aufweisen und vergleichsweise spröde sind, müssen hierbei enge Fertigungstoleranzen eingehalten werden, um Druckspitzen und somit Kraftspitzen an den Keramikplatten zu vermeiden. Der diesbezüglich erforderliche Aufwand bei der Herstellung der Wärmetauscher ist vergleichsweise groß.

Ein gattungsgemäßes thermoelektrisches Modul ist beispielsweise aus der US 5,837,929 bekannt. Es besitzt eine verbesserte Kopplung zwischen den Keramikplatten und den Metallbrücken durch eine dazwischen angeordnete Goldbeschichtung.

Ein anderes thermoelektrisches Modul ist aus der US 2011/0275165 A1 bekannt. Dort sind die Keramikplatten im Bereich der Metallbrücken mit Öffnungen und Nuten versehen, die im Wartungsfall ein Ausmessen und Reparieren der elektrischen Kontakte zwischen den Metallbrücken und den Halbleiterbeinen ermöglichen.

Aus der DE 10 2010 063 460 B3 ist ein Blockheizkraftwerk bekannt, das eine Brennkraftmaschine, einen Wärmespeicher und einen Wärmeübertrager aufweist, wobei der Wärmeübertrager einerseits in eine Abgasleitung der Brennkraftmaschine und andererseits in einen Kühlkreis der Brennkraftmaschine eingebunden ist, in den auch der Wärmespeicher eingebunden ist.

Ein anderes thermoelektrisches Modul ist aus der GB2119170 bekannt.

Die vorliegende Erfindung beschäftigt sich mit dem Problem, für ein thermoelektrisches Modul der eingangs genannten Art bzw. für einen damit ausgestatteten Wärmetauscher bzw. für eine damit ausgestattete Abgasanlage bzw. für eine damit ausgestattete Brennkraftmaschine eine verbesserte Ausführungsform anzugeben, die sich insbesondere durch eine reduzierte Empfindlichkeit gegenüber einer Druckbelastung auszeichnet.

Dieses Problem wird erfindungsgemäß durch den Gegenstand des unabhängigen Anspruchs gelöst. Vorteilhafte Ausführungsformen sind Gegenstand der abhängigen Ansprüche.

Die Erfindung beruht auf dem allgemeinen Gedanken, die jeweilige Keramikplatte zu segmentieren. Die Segmentierung der Keramikplatte erfolgt dabei derart, dass dadurch mehrere Keramikplattensegmente mit ihren Oberflächen zueinander fluchtend nebeneinander angeordnet sind. Zweckmäßig erfolgt die Segmentierung dabei so, dass die Keramikplattensegmente jeweils an mehreren Metallbrücken flächig anliegen und an mehreren Metallbrücken befestigt sind. Durch die Segmentierung der Keramikplatte können sich die einzelnen Keramikplattensegmente relativ zueinander bewegen, wodurch Druckspitzen abgebaut werden können. Sofern die Keramikplatte eben ist, sind die Keramikplattensegmente in der Ebene der Keramikplatte nebeneinander angeordnet. Sofern die Keramikplatte gekrümmt ist, sind die Keramikplattensegmente entsprechend der Krümmung der Keramikplatte nebeneinander angeordnet.

Bei einer Ausführungsform können die Keramikplattensegmente aneinander anstoßen, so dass sie jeweils an einem Stoß aneinander anliegen. Hierdurch ergibt sich ein besonders einfacher Aufbau für das jeweilige Modul. Die Keramikplattensegmente liegen im jeweiligen Stoß über Stoßkanten aneinander an. Zumindest bei einem Keramikplattensegment kann die jeweilige Stoßkante abgerundet sein, um die Gefahr von Beschädigungen bei Relativbewegungen der aneinander stoßenden Keramikplattensegmente zu reduzieren.

Besonders zweckmäßig ist eine Weiterbildung, bei der zwischen Keramikplattensegmenten, die in der flächigen Erstreckung der Keramikplatte benachbart sind, jeweils eine Fuge ausgebildet ist, derart, dass sich benachbarte Keramikplattensegmente nicht berühren. Das bedeutet, dass die einzelnen Keramikplattensegmente berührungslos zueinander angeordnet sind, so dass Relativbewegungen der Keramikplattensegmente zueinander insbesondere keinen Verschleiß durch Reibung der Keramikplattensegmente aneinander bewirken. Durch die Fugen können sich die Keramikplattensegmente freier relativ zueinander bewegen. Die jeweilige Fuge kann dabei vergleichsweise schmal konzipiert sein. Insbesondere kann eine Fugenbreite kleiner sein als eine Dicke der Keramikplatte.

Entsprechend einer vorteilhaften Ausführungsform kann die jeweilige Fuge mit einer elastischen Fugenmasse gasdicht verschlossen sein. Die Halbleiterbeine, die zwischen den Keramikplatten angeordnet sind, weisen eine vergleichsweise hohe Empfindlichkeit gegenüber Sauerstoff auf. Durch gasdichtes Verschließen der Fugen kann vermieden werden, dass beispielsweise Umgebungsluft durch die Fugen zu den Halbleiterbeinen gelangt. Durch die Elastizität der Fugenmasse kann dabei die Beweglichkeit der Keramikplattensegmente zueinander erhalten bleiben.

Gemäß einer vorteilhaften Weiterbildung kann als Fugenmasse ein Wärmeleitklebstoff verwendet werden, der auch zum Befestigen der Keramikplattensegmente an den Metallbrücken verwendet wird. Hierdurch lässt sich die Herstellung der thermoelektrischen Module vereinfachen, da beispielsweise das Ausfüllen der Fugen und das Verkleben der Keramikplattensegmente mit den Metallbrücken simultan durchgeführt werden kann.

Alternativ kann als Fugenmasse auch eine Vergussmasse verwendet werden, mit der auch die Zwischenräume benachbarter Halbleiterbeine innerhalb des jeweiligen thermoelektrischen Moduls ausgegossen sind. Auch diese Maßnahme ermöglicht eine einfache Herstellung der thermoelektrischen Module, da das Ausgießen der Zwischenräume und das Füllen der Fugen simultan durchführbar sind.

Bei einer vorteilhaften Ausführungsform können die Keramikplattensegmente gezielt so angeordnet sein, dass die Stöße bzw. die Fugen weitgehend deckungsgleich zu Lücken verlaufen, die an dieser Seite zwischen benachbarten Metallbrücken ausgebildet sind. Durch diese Gestaltung ergibt sich eine besonders hohe Beweglichkeit benachbarter Keramikplattensegmente zueinander.

Bei einer anderen vorteilhaften Ausführungsform können die LEG-Paare innerhalb des thermoelektrischen Moduls regelmäßig angeordnet sein, derart, dass sich für die Metallbrücken eine rechtwinkelige Gitterstruktur ergibt. Zweckmäßig sind bei einer derartigen Ausführungsform die Keramikplattensegmente rechteckförmig gestaltet. Auf diese Weise können die Keramikplattensegmente insbesondere besonders einfach so geformt und angeordnet werden, dass die Fugen deckungsgleich zu den Lücken zwischen benachbarten Metallbrücken verlaufen.

Bei einer anderen vorteilhaften Ausführungsform kann vorgesehen sein, dass sowohl an der Warmseite als auch an der Kaltseite jeweils eine derartige segmentierte Keramikplatte angeordnet ist. Durch diese Maßnahme ergibt sich für das jeweilige thermoelektrische Modul eine besonders hohe Flexibilität und Elastizität gegenüber Druckbelastungen. Vorzugsweise sind die beiden Keramikplatten an der Warmseite und an der Kaltseite unterschiedlich segmentiert, derart, dass sich verschiedene Fugenverläufe ergeben, die deckungsgleiche Fugen vermeiden.

Bei einem erfindungsgemäßen Wärmetauscher sind zumindest ein Heizrohr zum Führen eines Heizfluids und zumindest ein Kühlrohr zum Führen eines Kühlfluids vorgesehen. Ferner ist zumindest ein thermoelektrisches Modul der vorstehend beschriebenen Art vorgesehen, das in einer Stapelrichtung zwischen dem Heizrohr und dem Kühlrohr angeordnet ist, so dass die Warmseite des thermoelektrischen Moduls dem Heizrohr zugewandt ist, während die Kaltseite des thermoelektrischen Moduls dem Kühlrohr zugewandt ist.

In einem Stapel, in dem Heizrohre, Kühlrohre und thermoelektrische Module aufeinander gestapelt sind, können Unebenheiten der Rohroberflächen zu Druckspitzen an den Keramikplatten führen. Durch die Segmentierung der Keramikplatten können diese Druckspitzen Relativbewegungen zwischen den Keramikplattensegmenten erzeugen, wodurch die Druckspitzen abgebaut werden, wodurch die Gefahr einer Zerstörung oder Beschädigung der Keramikplatte reduziert ist.

Gemäß einer vorteilhaften Ausführungsform des Wärmetauschers kann in der Stapelrichtung zwischen dem Kühlrohr und der an der Kaltseite angeordneten Keramikplatte eine elastische Wärmeleitschicht, z.B. eine Graphitfolie, angeordnet sein. Zusätzlich oder alternativ kann in der Stapelrichtung zwischen dem Heizrohr und der an der Warmseite angeordneten Keramikplatte eine elastische Wärmeleitschicht, z.B. eine Graphitfolie, angeordnet sein. Bei einer derartigen Ausführungsform erfolgt die Kontaktierung zwischen dem thermoelektrischen Modul und dem jeweiligen Rohr nicht direkt, sondern mittelbar über die jeweilige Wärmeleitschicht. Eine derartige elastische Wärmeleitschicht, wie z.B. eine Graphitfolie, ist zum einen elastisch und besitzt zum anderen eine erhöhte Wärmeleitfähigkeit, wodurch die Wärmeübertragung zwischen der jeweiligen Keramikplatte und dem jeweiligen Rohr verbessert werden kann. Gleichzeitig kann die elastische Wärmeleitschicht Oberflächenunebenheiten des jeweiligen Rohrs und gegebenenfalls der jeweiligen Keramikplatte durch elastische und/oder plastische Deformation ausgleichen.

Entsprechend einer anderen Ausführungsform des Wärmetauschers können die Rohre und das jeweilige thermoelektrische Modul in der Stapelrichtung verspannt sein. Diese Verspannung kann mit Hilfe eines Gehäuses realisiert werden, in dem beim Schließen des Gehäuses eine entsprechende Vorspannkraft erzeugt wird. Ebenso ist es möglich, den Wärmetauscher mit einer Vorspanneinrichtung auszustatten, welche die Vorspannkraft auf den Stapel aus den Rohren und dem jeweiligen thermoelektrischen Modul einleitet. Beispielsweise kann eine derartige Vorspanneinrichtung zwei Endplatten aufweisen, die bezüglich der Stapelrichtung beiderseits des Stapels angeordnet sind, so dass sich der Stapel zwischen den beiden Endplatten befindet. Ferner sind die Endplatten über Zuganker miteinander verspannt, um über die Endplatten die gewünschte Vorspannung in den Stapel einleiten zu können.

Gemäß einer anderen vorteilhaften Ausführungsform des Wärmetauschers können mehrere Heizrohre und mehrere Kühlrohre sowie mehrere thermoelektrische Module in der Stapelrichtung einander abwechselnd gestapelt sein.

Eine erfindungsgemäße Abgasanlage, die bei einer Brennkraftmaschine vorzugsweise in einem Kraftfahrzeug, zur Anwendung kommen kann, umfasst eine Abgasleitung, in die ein Wärmetauscher der vorstehend beschriebenen Art eingebunden ist, so dass in der Abgasleitung geführtes Abgas das wenigstens eine Heizrohr des Wärmetauschers durchströmt und somit als Heizfluid dient.

Eine erfindungsgemäße Brennkraftmaschine, die insbesondere in einem Kraftfahrzeug verwendet wird, umfasst einen Motorblock, der mehrere Brennräume enthält, eine Abgasanlage zum Abführen von Abgas von den Brennräumen sowie einen Wärmetauscher der vorstehend beschriebenen Art, der in die Abgasanlage und in einen Kühlkreis so eingebunden ist, dass das Abgas durch das wenigstens eine Heizrohr strömt und das Kühlmittel des Kühlkreises durch das wenigstens eine Kühlrohr strömt.

Beim Kühlkreis kann es sich um einen Kühlkreis zum Kühlen des Motorblocks, also um einen Motor-Kühlkreis handeln. Alternativ kann es sich beim Kühlkreis auch um einen vom Motor-Kühlkreis unabhängigen Kühlkreis handeln, der insbesondere auf einem anderen Temperaturniveau betrieben wird als der Motor-Kühlkreis.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch
- Fig. 1: eine stark vereinfachte, schaltplanartige Prinzipdarstellung einer Brennkraftmaschine,
- Fig. 2: einen stark vereinfachten Querschnitt eines Wärmetauschers,
- Fig. 3: einen stark vereinfachten Querschnitt eines thermoelektrischen Moduls,
- Fig. 4: eine vereinfachte Draufsicht auf das thermoelektrische Modul entsprechend einer Blickrichtung IV in Fig. 3.

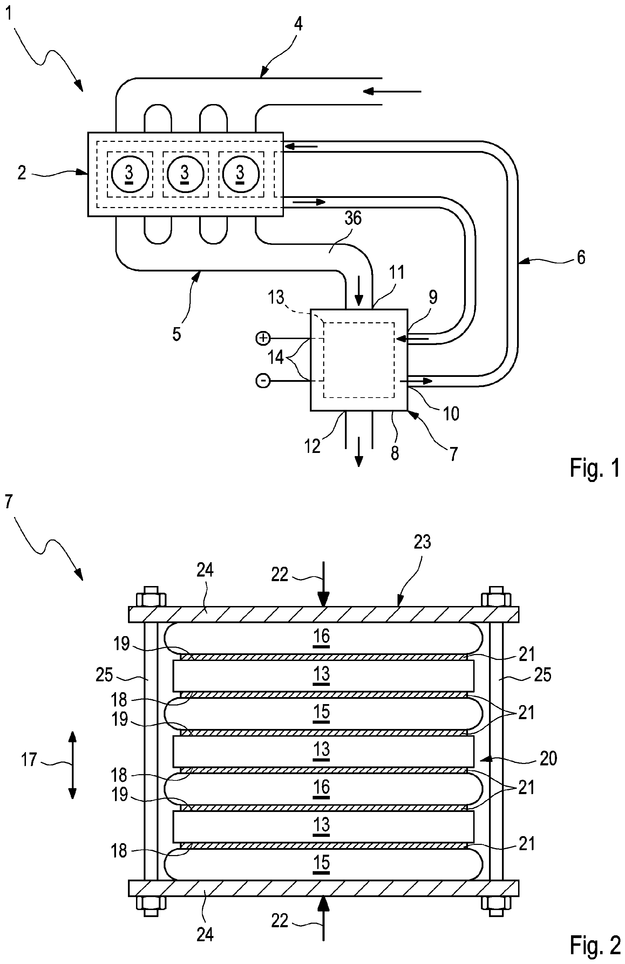

Entsprechend Figur 1 umfasst eine Brennkraftmaschine 1, die bevorzugt in einem Kraftfahrzeug zum Einsatz kommen ein, einen Motorblock 2, der mehrere Brennräume 3 enthält, eine Frischluftanlage 4 zur Versorgung der Brennräume 3 mit Frischluft und eine Abgasanlage 5 zum Abführen von Abgas von den Brennräumen 3. Des Weiteren ist die Brennkraftmaschine 1 mit einem Kühlkreis 6 ausgestattet, mit dessen Hilfe der Motorblock 2 gekühlt werden kann. Dabei ist klar, dass im Kühlkreis 6 außerdem ein hier nicht gezeigter Kühler, gegebenenfalls in Verbindung mit einem Gebläse, vorgesehen sein kann, um das im Kühlkreis 6 geführte Kühlmittel entsprechend kühlen zu können. Der zum Kühlen des Motorblocks 2 dienende Kühlkreis 6 kann auch als Motor-Kühlkreis oder Primär-Kühlkreis bezeichnet werden. Zusätzlich zu diesem Primär-Kühlkreis 6 kann optional ein hier nicht gezeigter separater Kühlkreis vorgesehen sein, der auch als Sekundär-Kühlkreis bezeichnet werden kann und der insbesondere einen eigenen Kühler, optional ein eigenes Gebläse, und ein separates Kühlmittel aufweisen kann. Der Sekundär-Kühlkreis kann insbesondere auf einem anderen Temperaturniveau betrieben werden als der Primär-Kühlkreis 6.

Die Brennkraftmaschine 1 ist außerdem mit einem Wärmetauscher 7 ausgestattet, dessen Gehäuse 8 einen Kühlmitteleinlass 9, einen Kühlmittelauslass 10, einen Heizmitteleinlass 11 und einen Heizmittelauslass 12 aufweist. Der Wärmetauscher 7 ist über seinen Heizmitteleinlass 11 und seinen Heizmittelauslass 12 in die Abgasanlage 5 bzw. in eine Abgasleitung 36 der Abgasanlage 5 fluidisch eingebunden, wobei das Abgas im Wärmetauscher 7 als Heizmittel bzw. Heizfluid dient. Ferner ist der Wärmetauscher 7 über seinen Kühlmitteleinlass 9 und seinen Kühlmittelauslass 10 in den Kühlkreis 6 eingebunden, dessen Kühlmittel auch im Wärmetauscher 7 als Kühlmittel bzw. Kühlfluid dient. Im gezeigten Beispiel ist der Wärmetauscher 7 somit in den Primär-Kühlkreis 6 eingebunden. Bei einer alternativen Ausführungsform kann der Wärmetauscher 7 auch in den vorstehend genannten Sekundär-Kühlkreis eingebunden sein.

Der Wärmetauscher 7 enthält außerdem zumindest ein thermoelektrisches Modul 13, das im Inneren des Wärmetauschers 7 mit dem Heizfluid und mit dem Kühlfluid wärmeübertragend gekoppelt ist. Am Gehäuse 18 sind elektrische Anschlüsse 14 ausgebildet, die mit dem jeweiligen thermoelektrischen Modul 13 entsprechend elektrisch verbunden sind.

Entsprechend Figur 2 umfasst der Wärmetauscher 7 mehrere Heizrohre 15 zum Führen des Heizfluids, mehrere Kühlrohre 16 zum Führen des Kühlfluids und mehrere thermoelektrische Module 13, die in einer Stapelrichtung 17 jeweils zwischen einem Heizrohr 15 und einem Kühlrohr 16 angeordnet sind. Das jeweilige thermoelektrische Modul 13 weist eine Warmseite 18 und eine Kaltseite 19 auf, die in der Stapelrichtung 18 voneinander abgewandt sind. Die Anordnung der thermoelektrischen Module 13 und der Heizrohre 15 sowie der Kühlrohre 16 bildet einen Stapel 20, in dem die jeweilige Warmseite 18 einem Heizrohr 15 zugewandt ist und in dem die jeweilige Kaltseite 19 einem Kühlrohr 16 zugewandt ist. Im Beispiel der Figur 2 ist außerdem in der Stapelrichtung 17 zwischen dem jeweiligen thermoelektrischen Modul 13 und dem jeweiligen Rohr 15, 16 jeweils eine Wärmeleitschicht 21 angeordnet, bei der es sich vorzugsweise um eine Graphitfolie handelt, die im Folgenden ebenfalls mit 21 bezeichnet werden kann.

In der Ansicht der Fig. 2 ist in einem nicht näher bezeichneten Zwischenraum, der sich in der Stapelrichtung 17 zwischen zwei benachbarten Rohren 15, 16 befindet, jeweils nur ein solches thermoelektrisches Modul 13 erkennbar. Es ist klar, dass in dem jeweiligen Zwischenraum in einer5 Längsrichtung des Stapels 20, die senkrecht auf der Zeichnungsebene der Fig. 2 steht, auch mehrere derartige thermoelektrische Module 13 hintereinander angeordnet sein können.

Der Stapel 20 ist entsprechend Pfeilen 22 in der Stapelrichtung 17 verspannt, wodurch sich die Rohre 15, 16 in der Stapelrichtung 17 über die Gaphitfolie 21 am jeweiligen thermoelektrischen Generator 13 vorgespannt abstützen. Die Vorspannkraft 22 wird im Beispiel der Figur 2 mit Hilfe einer Vorspanneinrichtung 23 realisiert, die im Gehäuse 8 des Wärmetauschers 7 angeordnet sein kann oder durch das Gehäuse 8 des Wärmetauschers 7 selbst gebildet sein kann. Im Beispiel der Figur 2 umfasst die Vorspanneinrichtung 23 zwei Endplatten 24, die in der Stapelrichtung 17 beiderseits des Stapels 20 angeordnet sind und in der Stapelrichtung 17 zwischen sich den Stapel 20 aufnehmen. Dabei liegen die Endplatten 24 jeweils am äußersten Rohr 15 bzw. 16 des Stapels 20 an. Ferner sind die Endplatten 24 mit Hilfe von Zugankern 25 aufeinander zu verspannt, wodurch die in der Stapelrichtung 17 orientierte Vorspannkraft 22 erzeugt und auf den Stapel 20 übertragen wird.

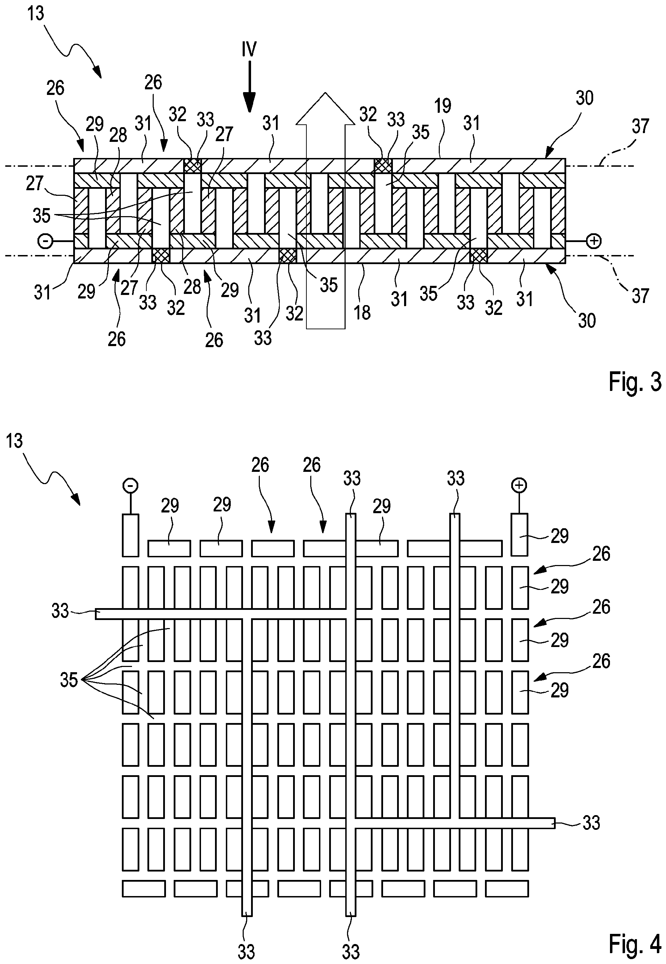

Gemäß den Figuren 3 und 4 umfasst das jeweilige thermoelektrische Modul 13 eine Vielzahl von Beinpaaren 26 oder LEG-Paaren 26. Jedes LEG-Paar 26 weist ein p-dotiertes Halbleiterbein 27 und ein n-dotiertes Halbleiterbahn 28 auf, die über Metallbrücken 29 miteinander elektrisch kontaktiert sind.

Des Weiteren ist sowohl an der Warmseite 18 als auch an der Kaltseite 19 jeweils eine Keramikplatte 30 angeordnet, die elektrisch isolierend ist. An der jeweiligen Keramikplatte 30 liegen die Metallbrücken 29 flächig an. Ferner sind die Metallbrücken 29 an der jeweiligen Keramikplatte 30 befestigt. Hierzu kann ein entsprechender Klebstoff verwendet werden, der sich insbesondere durch eine besonders hohe Wärmeleitfähigkeit auszeichnet und dementsprechend auch als Wärmeleitklebstoff bezeichnet werden kann. Anstelle einer Klebstoffverbindung ist grundsätzlich auch eine Stoffschlussverbindung, insbesondere eine Lötverbindung, beispielsweise mittels eines Aktivlots, denkbar. Die Keramikplatten 30 sind im dargestellten Beispiel eben konzipiert und erstrecken sich, zumindest im unverbauten Zustand des jeweiligen thermoelektrischen Moduls 13, jeweils in einer Plattenebene 37. Grundsätzlich sind auch gekrümmte Keramikplatten 30 denkbar, die sich dann in oder entlang bzw. entsprechend einer Plattenkrümmung erstrecken.

Die jeweilige Keramikplatte 30 ist segmentiert, so dass die jeweilige Keramikplatte 30 mehrere Keramikplattensegmente 31 umfasst, die in der Plattenebene 37 des jeweiligen Keramikplatte 30 oder gemäß der Plattenkrümmung nebeneinander angeordnet sind. Im Beispiel der Figur 3 sind in der gewählten Schnittebene an der Kaltseite 19, also oben, drei Keramikplattensegmente 31 erkennbar, während unten, also an der Warmseite 18 vier Keramikplattensegmente 31 erkennbar sind. Zweckmäßig erfolgt die Segmentierung der jeweiligen Keramikplatte 30 derart, dass an jedem Keramikplattensegment 31 jeweils mehrere Metallbrücken 29 flächig anliegen und daran befestigt sind. Des Weiteren ist bei den hier gezeigten Beispielen zwischen in der Plattenebene 37 benachbarten Keramikplattensegmenten 31 jeweils eine Fuge 32 ausgebildet, die dafür sorgt, dass sich die benachbarten Keramikplattensegmente 31 nicht berühren. Zweckmäßig ist die jeweilige Fuge 32 mit einer vorzugsweise elastischen Fugenmasse 33 gasdicht verschlossen. Als Fugenmasse 33 kommt beispielsweise der zuvor genannte Wärmeleitklebstoff in Frage, der auch zum Befestigen der Metallbrücken 29 an den Keramikplattensegmenten 31 verwendet wird. Alternativ kann als Fugenmasse 33 auch eine Vergussmasse verwendet werden, mit der die Zwischenräume 34 benachbarter Halbleiterbeine 27, 28 innerhalb des jeweiligen thermoelektrischen Moduls 13 ausgegossen sind. In der Schnittansicht der Figur 3 ist die Vergussmasse nicht dargestellt.

Bei einer anderen Ausführungsform kann vorgesehen sein, dass die benachbarten Keramikplattensegmente 31 aneinander anstoßen und sich dementsprechend jeweils entlang eines Stoßes berühren. Das jeweilige Keramikplattensegment 31 besitzt im jeweiligen Stoß eine Stoßkante, die an einer Stoßkante des benachbarten Keramikplattensegments 31 im jeweiligen Stoß anliegt. Zumindest eine der Stoßkanten kann abgerundet sein. Vorzugsweise sind im jeweiligen Stoß beide Stoßkanten abgerundet.

Bei der Darstellung der Figur 4 sind die Keramikplatten 30 weggelassen. Außerdem sind nur die Metallbrücken 29 der Kaltseite 19 erkennbar. Des Weiteren ist die Fugenmasse 33 angedeutet, um den Verlauf der Fugen 32 bzw. der Stöße zwischen benachbarten Keramikplattensegmenten 31 derjenigen Keramikplatte 30 zu veranschaulichen, die der Kaltseite 19 zugeordnet ist. Erkennbar erfolgt die Segmentierung dieser Keramikplatte 30 derart, dass sich die Keramikplattensegmente 31 gezielt so anordnen lassen, dass die Fugen 32 bzw. die Stöße, deren Verlauf in Figur 4 dem Verlauf der Fugenmasse 33 entspricht, deckungsgleich zu Lücken 35 verlaufen, die an der Kaltseite 19 zwischen benachbarten Metallbrücken 29 vorhanden sind. Diese spezielle Anordnung der Keramikplattensegmente 31 ist auch in der Schnittansicht der Figur 3 erkennbar. Auch hier verlaufen die Fugen 32 deckungsgleich zu den Lücken 35. Da die Halbleiterbeine 27, 28 eine gewisse Biegeelastizität besitzen, können die einzelnen Keramikplattensegmente 31 relativ zueinander bewegt werden, ohne dass dabei unzulässig hohe Kräfte innerhalb der Struktur des thermoelektrischen Moduls 13 auftreten.

Wie sich insbesondere Figur 4 besonders deutlich entnehmen lässt, sind die LEG-Paare 26 innerhalb des thermoelektrischen Moduls 13 zweckmäßig regelmäßig angeordnet, und zwar derart, dass sich für die Metallbrücken 29 eine rechtwinklige Gitterstruktur an der jeweiligen Seite, also an der Warmseite 18 oder an der Kaltseite 19 des thermoelektrischen Moduls 13 ergibt. In diesem Fall sind auch die Keramikplattensegmente 31 zweckmäßig rechteckförmig gestaltet.

## Patentansprüche

1. Thermoelektrisches Modul zur Wandlung von thermischer Energie in elektrische Energie,
- mit einer Vielzahl von Bein-Paaren (26), die jeweils ein p-dotiertes Halbleiterbein (27) und ein n-dotiertes Halbleiterbein (28) aufweisen, die über Metallbrücken (29) elektrisch miteinander kontaktiert sind,
- mit wenigstens einer elektrisch isolierenden Keramikplatte (30), die an einer Warmseite (18) des thermoelektrischen Moduls (13) oder an einer Kaltseite (19) des thermoelektrischen Moduls (13) angeordnet und an den dieser Seite (18, 19) zugeordneten Metallbrücken (29) flächig anliegt und daran befestigt ist,
- wobei sowohl an der Warmseite (18) als auch an der Kaltseite (19) eine solche Keramikplatte (30) angeordnet ist, wobei,
- dass die jeweilige Keramikplatte (30) segmentiert ist, so dass mehrere Keramikplattensegmente (31) nebeneinander angeordnet sind, die jeweils an mehreren Metallbrücken (29) flächig anliegen und daran befestigt sind,
- dass die an der Warmseite (18) angeordnete Keramikplatte (30) anders segmentiert ist als die an der Kaltseite (19) angeordnete Keramikplatte (30).

2. Modul nach Anspruch 1,
**dadurch gekennzeichnet,**
**dass** benachbarte Keramikplattensegmente (31) aneinander anstoßen und sich jeweils entlang eines Stoßes berühren.

3. Modul nach Anspruch 1,
**dadurch gekennzeichnet,**
**dass** zwischen benachbarten Keramikplattensegmenten (31) jeweils eine Fuge (32) ausgebildet ist, so dass sich benachbarte Keramikplattensegmente (31) nicht berühren.

4. Modul nach Anspruch 3,
**dadurch gekennzeichnet,**
**dass** die jeweilige Fuge (32) mit einer Fugenmasse (33) gasdicht verschlossen ist.

5. Modul nach Anspruch 4,
**dadurch gekennzeichnet,**
**dass** als Fugenmasse (33) ein Wärmeleitklebstoff verwendet wird, der auch zum Befestigen der Keramikplattensegmente (31) an der Metallbrücke (29) verwendet wird.

6. Modul nach Anspruch 4,
**dadurch gekennzeichnet,**
**dass** als Fugenmasse (33) eine Vergussmasse verwendet wird, mit der auch die Zwischenräume (34) benachbarter Halbleiterbeine (27, 28) innerhalb des jeweiligen thermoelektrischen Moduls (13) ausgegossen sind.

7. Modul nach einem der Ansprüche 2 bis 6,
**dadurch gekennzeichnet,**
**dass** die Keramikplattensegmente (31) so angeordnet sind, dass der jeweilige Stoß oder die jeweilige Fuge (32) deckungsgleich zu Lücken (35) verläuft, die an dieser Seite (18, 19) zwischen benachbarten Metallbrücken (29) ausgebildet sind.

8. Modul nach einem der Ansprüche 1 bis 7,
**dadurch gekennzeichnet,**
- **dass** die Bein-Paare (26) innerhalb des thermoelektrischen Moduls (13) regelmäßig angeordnet sind, derart, dass sich für die Metallbrücken (29) eine rechtwinklige Gitterstruktur an der jeweiligen Seite (18, 19) ergibt,
- **dass** die Keramikplattensegmente (31) rechteckförmig sind.

9. Wärmetauscher,
- mit wenigstens einem Heizrohr (15) zum Führen eines Heizfluids,
- mit mindestens einem Kühlrohr (16) zum Führen eines Kühlfluids,
- mit mindestens einem thermoelektrischen Modul (13) nach einem der Ansprüche 1 bis 8, das in einer Stapelrichtung (17) zwischen dem Heizrohr (15) und dem Kühlrohr (16) angeordnet ist, so dass die Warmseite (18) des thermoelektrischen Moduls (13) dem Heizrohr (15) zugewandt ist und die Kaltseite (19) des thermoelektrischen Moduls (13) dem Kühlrohr (16) zugewandt ist.

10. Wärmetauscher nach Anspruch 9,
**dadurch gekennzeichnet,**
- **dass** in der Stapelrichtung (17) zwischen dem Kühlrohr (16) und der an der Kaltseite (19) angeordneten Keramikplatte (30) eine Wärmeleitschicht (21) angeordnet ist, und/oder
- **dass** in der Stapelrichtung (17) zwischen dem Heizrohr (15) und der an Warmseite (18) angeordneten Keramikplatte (30) eine Wärmeleitschicht (21) angeordnet ist.

11. Wärmetauscher nach Anspruch 9 oder 10,
**dadurch gekennzeichnet,**
**dass** die Rohre (15, 16) und das wenigstens eine thermoelektrische Modul (13) in der Stapelrichtung (17) verspannt sind.

12. Wärmetauscher nach einem der Ansprüche 9 bis 11,
**dadurch gekennzeichnet,**
**dass** mehrere Heizrohre (15), mehrere Kühlrohre (16) und mehrere thermoelektrische Module (13) in der Stapelrichtung (17) einander abwechselnd gestapelt sind.

13. Abgasanlage für eine Brennkraftmaschine (1), mit einer Abgasleitung (36), in die ein Wärmetauscher (7) nach einem der Ansprüche 9 bis 12 eingebunden ist, so dass in der Abgasleitung (36) geführtes Abgas das wenigstens eine Heizrohr (15) des Wärmetauschers (7) durchströmt.

14. Brennkraftmaschine, insbesondere für ein Kraftfahrzeug,
- mit einem Motorblock (2), der mehrere Brennräume (3) enthält,
- mit einer Abgasanlage (5) zum Abführen von Abgas von den Brennräumen (3),
- mit einem Wärmetauscher (7) nach einem der Ansprüche 9 bis 12, der in die Abgasanlage (5) und in einen Kühlkreis (6) so eingebunden ist, dass das Abgas durch das wenigstens eine Heizrohr (15) strömt und das Kühlmittel des Kühlkreises (6) durch das wenigstens eine Kühlrohr (16) strömt.

## Claims

1. A thermoelectric module for converting thermal energy into electrical energy,
- with a plurality of leg pairs (26), each of which comprise a p-doped semiconductor leg (27) and an n-doped semiconductor leg (28), which are electrically contacted with one another via metal bridges (29),
- with at least one electrically insulating ceramic plate (30), which is arranged on a warm side (18) of the thermoelectric module (13) or on a cold side (19) of the thermoelectric module (13) and which lies flat against the metal bridges (29) assigned to this side (18, 19) and is fastened thereon,
- wherein both on the warm side (18) and also on the cold side (19) a segmented ceramic plate (30) is arranged,
**characterized in**
- **that** the respective ceramic plate (30) is segmented so that multiple ceramic plate segments (31) are arranged next to one another, each of which lie flat against multiple metal bridges (29) and are fastened thereon,
- **that** the segment plate (30) arranged on the warm side (18) is segmented differently than the segment plate (30) arranged on the cold side (19).

2. The module according to Claim 1, **characterized in that** adjacent ceramic plate segments (31) abut one another and each touch one another along a joint.

3. The module according to Claim 1, **characterized in that** between adjacent ceramic plate segments (31) a gap (32) each is formed, so that adjacent ceramic plate segments (31) do not touch one another.

4. The module according to Claim 3, **characterized in that** the respective gap (32) is sealed gas-tight with a grout (33).

5. The module according to Claim 4, **characterized in that** as grout (33) a heat conductive adhesive is used, which is also used for fastening the ceramic plate segments (31) to the metal bridge (29).

6. The module according to Claim 4, **characterized in that** as grout (33) a casting compound is used, with which the intermediate spaces (34) of adjacent semiconductor legs (27, 28) within the respective thermoelectric module (13) are also filled.

7. The module according to any one of the Claims 2 to 6, **characterized in that** the ceramic plate segments (31) are arranged so that the respective joint or the respective gap (32) runs congruently to breaks (35) which are formed on this side (18, 19) between adjacent metal bridges (29).

8. The module according to any one of the Claims 1 to 7, **characterized**
- **in that** the leg pairs (26) are regularly arranged within the thermoelectric module (13) in such a manner that for the metal bridges (29) a right-angled grid structure on the respective side (18, 19) is obtained,
- **in that** the ceramic plate segments (31) are rectangular.

9. A heat exchanger
- with at least one heating tube (15) for conducting a heating fluid,
- with at least one cooling tube (16) for conducting a cooling fluid,
- with at least one thermoelectric module (13) according to any one of the Claims 1 to 8, which in a stacking direction (17) is arranged between the heating tube (15) and the cooling tube (16), so that the warm side (18) of the thermoelectric module (13) faces the heating tube (15) and the cold side (19) of the thermoelectric module (13) faces the cooling tube (16) .

10. The heat exchanger according to Claim 9, **characterized**
- **in that** in the stacking direction (17) between the cooling tube (16) and the ceramic plate (30) arranged on the cold side (19) a heat conductive layer (21) is arranged, and/or
- **in that** in the stacking direction (17) between the heating tube (15) and the ceramic plate (30) arranged on the warm side (18) a heat conductive layer (21) is arranged.

11. The heat exchanger according to Claim 9 or 10, **characterized in that** the tubes (15, 16) and the at least one thermoelectric module (13) are clamped in the stacking direction (17).

12. The heat exchanger according to any one of the Claim 9 to 11, **characterized in that** the multiple heating tubes (15), multiple cooling tubes (16) and multiple thermoelectric modules (13) are stacked in the stacking direction (17) alternating one another.

13. An exhaust system for an internal combustion engine (1), with an exhaust line (36), into which a heat exchanger (7) according to any one of the Claims 9 to 12 is incorporated, so that exhaust gas conducted in the exhaust line (36) flows through the at least one heating tube (15) of the heat exchanger (7).

14. An internal combustion engine, in particular for a motor vehicle,
- with an engine block (2), containing multiple combustion chambers (3),
- with an exhaust system (5) for discharging exhaust gas from the combustion chambers (3),
- with a heat exchanger (7) according to any one of the Claims 9 to 12, which is incorporated in the exhaust system (5) and in a cooling circuit (6) so that the exhaust gas flows through the at least one heating tube (15) and the coolant of the cooling circuit (6) flows through the at least one cooling tube (16).

## Revendications

1. Module thermoélectrique pour transformer de l'énergie thermique en énergie électrique,
- avec une pluralité de paires de pattes (26), qui comportent à chaque fois une patte semi-conductrice à dopage p (27) et une patte semi-conductrice à dopage n (28), qui sont en contact électrique l'une avec l'autre par l'intermédiaire de ponts métalliques (29),
- avec au moins une plaque céramique (30) électriquement isolante, qui est agencée au niveau d'un côté chaud (18) du module thermoélectrique (13) ou au niveau d'un côté froid (19) du module thermoélectrique (13) et qui est adjacente par sa surface aux ponts métalliques (29) associés à ces côtés (18, 19) et est fixée à ceux-ci,
- dans lequel une plaque céramique (30) de ce type est agencée aussi bien au côté chaud (18) qu'au côté froid (19),
dans lequel
- la plaque céramique (30) respective est segmentée de telle sorte que plusieurs segments de plaque céramique (31) sont agencés les uns à côté des autres, lesquels sont adjacents par leur surface à chaque fois à plusieurs ponts métalliques (29) et sont fixés à ceux-ci,
- dans lequel la plaque céramique (30) agencée au niveau du côté chaud (18) est segmentée différemment de la plaque céramique (30) agencée du côté froid (19).

2. Module selon la revendication 1,
**caractérisé en ce que**
des segments de plaque céramique (31) voisins sont bout à bout et se touchent à chaque fois le long d'un bout.

3. Module selon la revendication 1,
**caractérisé en ce**
**qu'**un joint (32) est formé à chaque fois entre des segments de plaque céramique (31) voisins de sorte que des segments de plaque céramique (31) voisins ne se touchent pas.

4. Module selon la revendication 3,
**caractérisé en ce que**
le joint (32) respectif est obturé de manière étanche au gaz avec une masse d'étanchéité (33).

5. Module selon la revendication 4,
**caractérisé en ce**
**qu'**on utilise comme masse d'étanchéité (33) un adhésif thermoconducteur qui est aussi utilisé pour fixer les segments de plaque céramique (31) aux ponts métalliques (29).

6. Module selon la revendication 4,
**caractérisé en ce**
**qu'**on utilise comme masse d'étanchéité (33) une masse de remplissage avec laquelle les interstices (34) entre des pattes semi-conductrices voisines (27, 28) à l'intérieur du module thermoélectrique (13) respectif sont aussi scellés.

7. Module selon l'une quelconque des revendications 2 à 6,
**caractérisé en ce que**
les segments de plaque céramique (31) sont agencés de telle sorte que le bout respectif ou le joint respectif (32) s'étend de manière à recouvrir des vides (35) qui sont formés au niveau de ce côté (18, 19) entre des ponts métalliques (29) voisins.

8. Module selon l'une quelconque des revendications 1 à 7,
**caractérisé en ce que**
- les paires de pattes (26) sont agencées régulièrement à l'intérieur du module thermoélectrique (13) de telle sorte qu'il en résulte pour les ponts métalliques (29) une structure en grille à angles droits au niveau du côté (18, 19) respectif,
- les segments de plaque céramique (31) sont rectangulaires.

9. Échangeur de chaleur,
- avec au moins un tube de chauffage (15) destiné à conduire un fluide de chauffage,
- avec au moins un tube de refroidissement (16) destiné à conduire un fluide de refroidissement,
- avec au moins un module thermoélectrique (13) selon l'une quelconque des revendications 1 à 8, qui est agencé dans une direction d'empilement (17) entre le tube de chauffage (15) et le tube de refroidissement (16) de telle sorte que le côté chaud (18) du module thermoélectrique (13) est tourné vers le tube de chauffage (15) et le côté froid (19) du module thermoélectrique (13) est tourné vers le tube de refroidissement (16).

10. Échangeur de chaleur selon la revendication 9,
**caractérisé en ce que**
- une couche thermoconductrice (21) est agencée dans la direction d'empilement (17) entre le tube de refroidissement (16) et la plaque céramique (30) agencée au niveau du côté froid (19), et/ou
- une couche thermoconductrice (21) est agencée dans la direction d'empilement (17) entre le tube de chauffage (15) et la plaque céramique (30) agencée au niveau du côté chaud (18).

11. Échangeur de chaleur selon la revendication 9 ou 10,
**caractérisé en ce que**
les tubes (15, 16) et l'au moins un module thermoélectrique (13) sont serrés dans la direction d'empilement (17).

12. Échangeur de chaleur selon l'une quelconque des revendications 9 à 11,
**caractérisé en ce que**
plusieurs tubes de chauffage (15), plusieurs tubes de refroidissement (16) et plusieurs modules thermoélectriques (13) sont empilés en alternance dans la direction d'empilement (17).

13. Installation de gaz d'échappement pour un moteur à combustion interne (1), avec une conduite de gaz d'échappement (36), dans laquelle est intégré un échangeur de chaleur (7) selon l'une quelconque des revendications 9 à 12, de telle sorte que du gaz d'échappement conduit dans la conduite de gaz d'échappement (36) passe à travers l'au moins un tube de chauffage (15) de l'échangeur de chaleur (7).

14. Moteur à combustion interne, en particulier pour un véhicule automobile,
- avec un bloc-moteur (2) qui contient plusieurs chambres de combustion (3),
- avec une installation de gaz d'échappement (5) destinée à évacuer du gaz d'échappement des chambres de combustion (3),
- avec un échangeur de chaleur (7) selon l'une quelconque des revendications 9 à 12 qui est intégré de telle sorte dans l'installation de gaz d'échappement (5) et dans un circuit de refroidissement (6) que le gaz d'échappement s'écoule à travers au moins un tube de chauffage (15) et le fluide de refroidissement du circuit de refroidissement (6) s'écoule à travers l'au moins un tube de refroidissement (16).
